# FASCICULE DE BREVET EUROPEEN

(11) **EP 1 217 628 B1**
(45) Date de publication et mention de la délivrance du brevet: **14.05.2008**
(21) Numéro de dépôt: 01403280.9
(22) Date de dépôt: 18.12.2001
(51) Int. Cl.: G11C 16/32, G11C 7/10, G11C 7/20, G11C 29/00, G11C 7/22

(54) **Procédé et système d'ajustement d'une temporisation interne ou d'une référence associée dans un circuit intégré et circuit intégré correspondant**
Verfahren und System zum Einstellen eines Taktsignals oder anderer Eigenschaften einer integrierten Schaltungsanordnung sowie entsprechende integrierte Schaltungsanordnung
Method and system to adjust an internal temporisation or any other characteristic in an integrated circuit and integrated circuit thereof

(30) Priorité: 20.12.2000 FR 0016703
(43) Date de publication de la demande: 26.06.2002
(73) Titulaire: STMicroelectronics S.A., 92120 Montrouge (FR)
(72) Inventeur: Tailliet, Francois, 92593 Levallois-Perret Cedex (FR)
(74) Mandataire: Bentz, Jean-Paul

(56) Documents cités:
- US-A- 5 384 737
- US-A- 5 903 512
- US-A- 6 026 050

## Description

L'invention concerne un procédé d'ajustement d'une temporisation interne ou d'une référence associée dans un circuit intégré, et un circuit intégré comprenant des moyens permettant de mettre en oeuvre ledit procédé. L'invention s'applique aux circuits intégrés comprenant des circuits de référence, par exemple, des circuits de référence de tension, de courant, ou de durée. Une application particulière concerne le test des circuits intégrés en parallèle.

L'invention s'applique notamment aux mémoires non volatiles, pour ajuster la durée des impulsions de programmation appliquées aux cellules mémoire. Elle peut avoir d'autres applications comme par exemple, l'étalonnage d'une source de courant ou de tension, où l'étalonnage d'un potentiomètre électronique à réseau de résistances.

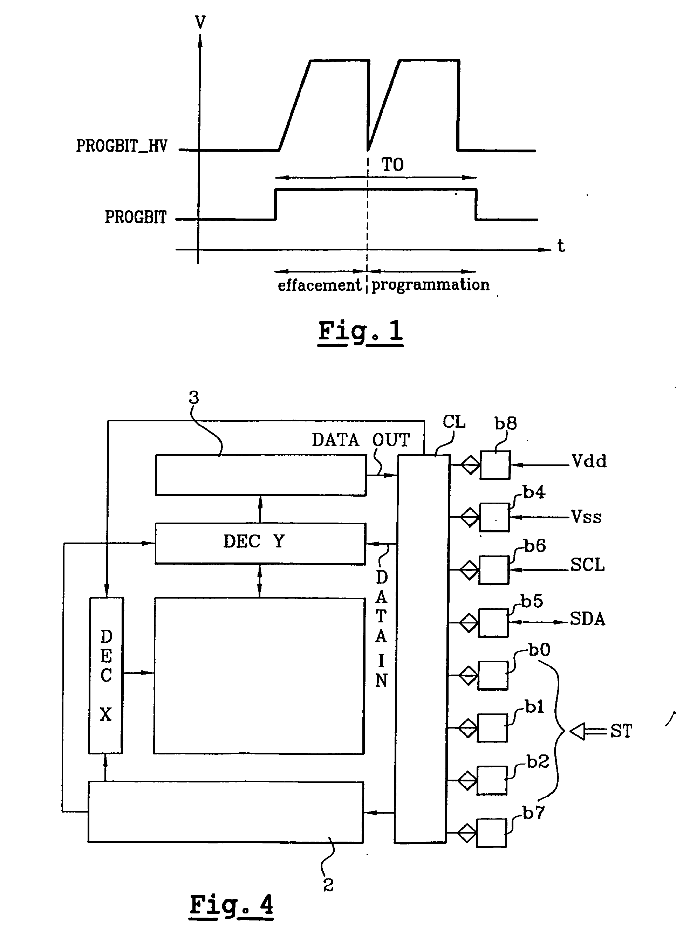

Dans un circuit à mémoire non volatile (EEPROM par exemple), un circuit de contrôle produit un signal de programmation qui comprend typiquement deux impulsions haute tension successives, pour réaliser d'abord l'effacement puis l'écriture. Ce signal de programmation PROGBIT-HV est représenté sur la figure 1. Il a notamment une durée totale T0 calibrée. Il est fourni par un circuit de génération haute tension activé par un signal logique PROGBIT de commande de programmation. Dans l'exemple le signal de programmation PROGBIT est à "1" pendant la phase d'effacement/programmation. Dans un exemple, la valeur typique de la durée T0 est de 5 millisecondes, dans une fenêtre de tolérance de 1 à 10 millisecondes. Ce signal de programmation PROGBIT-HV a une valeur de haute tension HV qui doit répondre également à des contraintes bien déterminées. Les contraintes sur les caractéristiques (durée, valeur haute tension) du signal de programmation sont déterminées afin d'assurer une programmation fiable.

La durée du signal de programmation doit notamment permettre de charger suffisamment les cellules mémoire. Quant à la durée maximale du signal de programmation, elle résulte habituellement des spécifications fonctionnelles de la mémoire.

En pratique, les caractéristiques du signal de programmation varient d'un circuit intégré à l'autre, en raison des dispersions intrinsèques au procédé technologique de fabrication mis en oeuvre.

En sortie de fabrication, les circuits intégrés sont testés. Ces tests permettent notamment d'écarter ceux dont les caractéristiques ne rentrent pas dans la gamme des valeurs admissibles (spécification des circuits intégrés).

L'idée à la base de l'invention, est de prévoir des dispositifs d'ajustements de ces caractéristiques, réalisés dans le circuit intégré. Ces dispositifs d'ajustement permettent de réduire l'influence de la dispersion des caractéristiques, liée au procédé technologique utilisé.

Si on prend la durée T0 du signal de commande de programmation PROGBIT, cette durée est obtenue à partir d'un circuit par lequel un courant de référence est utilisé pour charger et décharger un condensateur.

Le principe de l'invention est de faire mesurer par le testeur la durée du signal de programmation de l'invention représenté à la figure 1 (impulsion d'effacement + impulsion de programmation), pour en déduire une valeur d'étalonnage par rapport à la valeur typique T0. Cette valeur d'étalonnage est alors appliquée à un dispositif d'ajustement correspondant prévu dans le circuit intégré. Dans un exemple, le dispositif d'ajustement permet d'ajuster la capacité du condensateur, ou l'intensité du courant de référence, afin d'obtenir une durée de programmation ajustée, proche de la valeur typique T0.

En pratique, il s'agit donc :
- de mesurer la durée réelle Tr du signal de programmation dans le circuit intégré, sous des conditions normales de fonctionnement.
- d'en déduire la valeur d'étalonnage K_{E}, égale au rapport de la valeur typique T0 sur la valeur réelle mesurée Tr : K_{E} =T0/Tr.
- d'appliquer cette valeur d'étalonnage dans le dispositif d'ajustement de la durée de programmation, en sorte que l'on obtienne une valeur ajustée Ta proche de K_{E}.Tr, c'est à dire proche de la valeur typique T0 de la durée de programmation. La précision de la correction dépend de la précision du dispositif d'ajustement utilisé.

Avec un procédé d'étalonnage selon l'invention, il y a moins de dispersion entre les circuits intégrés, ce qui stabilise le fonctionnement des circuits. Le temps de programmation devient très stable et les performances des circuits intégrés plus proches. Il est alors possible d'optimiser la programmation des cellules mémoire.

Un problème de mise en oeuvre du procédé d'étalonnage selon l'invention, est qu'il nécessite une mesure préalable de la caractéristique à ajuster, ce qui ne peut se faire qu'en test. Le circuit doit aussi être testé après ajustement.

En outre, les circuits intégrés sont testés par un système de test automatique, en parallèle. En pratique, il n'est donc pas possible de faire mesurer individuellement la durée de programmation de chaque circuit intégré.

Pour être applicables à de tels systèmes de test, un procédé d'ajustement selon l'invention doit comprendre des étapes identiques pour tous les circuits intégrés, non individualisées.

Un objet de l'invention est un procédé d'ajustement de paramètres d'un circuit intégré qui satisfait toutes ces conditions.

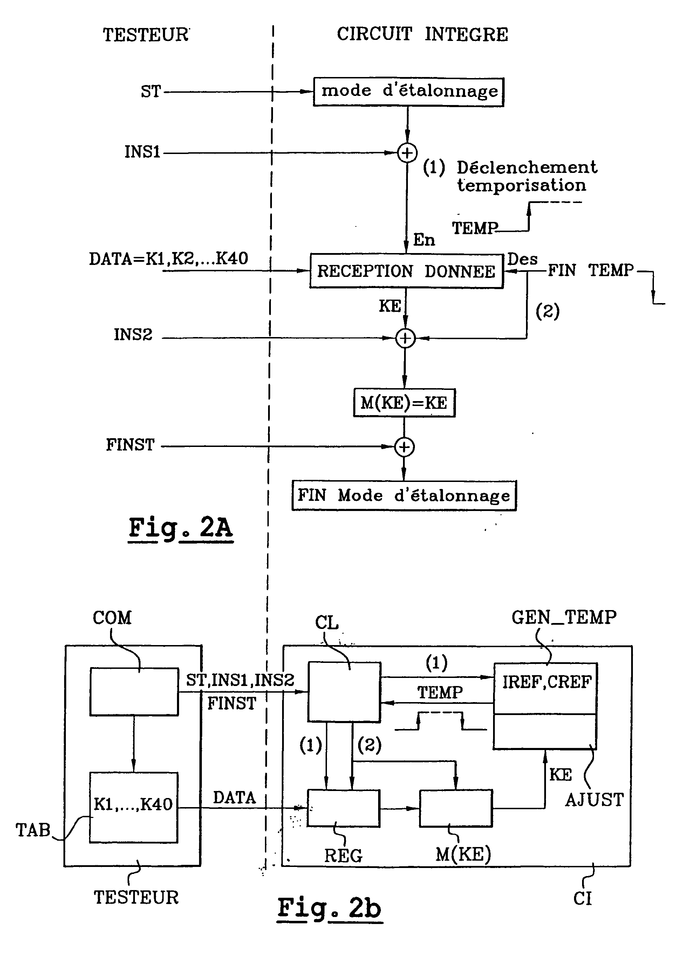

Le document US 5.903.512 décrit un circuit qui est capable de remplacer un signal intern avec un signal extern (SA-enable, fig.2) en faisant un test du circuit.

L'invention est définie par les revendications 1 et 18.

Selon l'invention, le procédé d'ajustement comprend l'activation par le testeur du signal de programmation du circuit intégré, puis l'envoi de valeurs d'étalonnage en séquence par le testeur. Chaque valeur d'étalonnage correspond au rapport de la valeur typique T0, sur la durée écoulée depuis l'activation du signal de programmation jusqu'à l'envoi de cette valeur. Dans un exemple dans lequel les valeurs d'étalonnage sont transmises selon le protocole série I2C, chaque valeur correspondant à un octet de donnée, si Kn est la nième valeur d'étalonnage envoyée, cette valeur d'étalonnage est ainsi égale à : Kn=T0/9n.TCK, où TCK est la période du signal d'horloge CK de la liaison série. La fin du signal de programmation déclenche l'enregistrement de la dernière valeur d'étalonnage envoyée (où en cours d'envoi). Cette valeur peut ensuite être programmée en mémoire non volatile.

Cette valeur d'étalonnage mémorisée est appliquée en entrée d'un dispositif d'ajustement associé à un circuit de référence dont est fonction la durée dudit signal de programmation. On obtient ainsi un circuit de référence ajusté. Un tel circuit de référence sera typiquement un circuit de référence de courant ou un condensateur (ou réseau de condensateur).

Par ce procédé, la durée ajustée du signal de programmation est égale ou proche de la valeur typique T0.

On notera que la valeur d'étalonnage est applicable à un dispositif d'ajustement de n'importe quelle référence dont dépend la durée du signal de programmation. Dans le cas typique où cette durée résulte de la charge d'un condensateur par un courant de référence, on peut ajuster soit le condensateur soit le courant, ce qui améliore les possibilités de réglage.

Cette valeur d'étalonnage peut en outre servir pour ajuster d'autres circuits de référence du même type que les circuits de référence liés au signal de programmation. En d'autres termes, en étalonnant la durée de la temporisation interne, on peut ajuster toute référence du circuit intégré issue d'une structure identique à celle d'un circuit de référence dont dépend la durée de la temporisation interne.

Il est par exemple habituel qu'un circuit intégré comprennent plusieurs sources de courant de référence. Au premier ordre, les dispersions des caractéristiques affectent ces sources de courant de la même façon. Ainsi, la même valeur d'étalonnage est-elle applicable aux différentes sources de courant de référence. On peut donc prévoir un dispositif d'ajustement associé à chaque source de courant, pour y appliquer la valeur d'étalonnage déterminée par le procédé d'ajustement selon l'invention.

De façon générale, on peut appliquer le procédé d'ajustement selon l'invention à tout type de circuit de référence ,- source de courant, source de tension, réseau de condensateurs ou de résistances-, auquel on peut faire correspondre une temporisation interne du circuit intégré.

Le procédé consiste alors à déclencher cette temporisation interne, la fin de cette temporisation interne permettant l'enregistrement dans le circuit intégré de la donnée d'étalonnage correspondante.

Avec un tel procédé selon l'invention, le testeur n'a pas à connaître la durée de la temporisation interne. On peut ainsi tester et étalonner simultanément en parallèle les circuits intégrés d'une même technologie, au moyen d'une table de valeurs d'étalonnage de la temporisation interne établie pour la dite technologie.

L'invention concerne donc un procédé d'ajustement de la durée d'une temporisation interne, à une valeur proche d'une valeur typique de cette durée, caractérisé en ce qu'il consiste à déclencher ladite temporisation interne dans ledit circuit intégré et à envoyer séquentiellement des valeurs d'étalonnage en entrée dudit circuit intégré, chaque valeur d'étalonnage étant égale au rapport de la valeur typique sur la durée écoulée depuis le déclenchement, l'expiration de la temporisation interne déterminant comme donnée d'étalonnage dudit circuit intégré, la dernière valeur d'étalonnage reçue ou celle en train d'être reçue, ladite donnée d'étalonnage étant appliquée à un dispositif d'ajustement de la durée de la dite temporisation interne.

Selon une autre caractéristique, la temporisation interne étant fonction d'au moins une référence fournie par un circuit de référence, le dispositif d'ajustement est appliqué au dit circuit de référence.

L'invention concerne aussi un procédé d'ajustement d'une référence dans un circuit intégré. On prévoit dans ledit circuit intégré un dispositif d'ajustement de la référence à ajuster à partir d'une donnée d'étalonnage et un circuit de génération d'une temporisation interne à partir de cette référence. En appliquant le procédé d'ajustement de la durée à la temporisation interne ainsi générée, on obtient la donnée d'étalonnage à appliquer au dispositif d'ajustement de cette référence.

L'invention concerne aussi un circuit intégré caractérisé en ce qu'il comprend un circuit de génération d'une temporisation interne à partir d'au moins une référence et des moyens d'ajustement de ladite référence, lesdits moyens d'ajustement comprenant des moyens d'enregistrement temporaire pour enregistrer des données envoyées sur une entrée de données du circuit intégré, lesdits moyens de mémorisation temporaire étant activés par le déclenchement de la temporisation interne, un élément de mémoire non volatile pour mémoriser la donnée contenue par lesdits moyens de mémorisation temporaire à l'expiration de ladite temporisation interne et au moins un dispositif d'ajustement d'un circuit de génération de ladite référence, la donnée contenue dans ledit élément de mémoire non volatile étant appliquée en entrée dudit dispositif d'ajustement.

L'invention concerne aussi un système de test de circuits intégrés en parallèle.

D'autres caractéristiques et avantages de l'invention sont détaillés dans la description suivante faite à titre indicatif et non limitatif et en référence aux dessins annexés, dans lesquels :
- la figure 1 déjà décrite montre la forme d'un signal de programmation appliqué aux cellules d'une mémoire EEPROM;
- les figures 2a et 2b représentent un organigramme représentatif d'un procédé d'ajustement selon l'invention appliqué à un circuit intégré et un schéma-bloc correspondant du testeur et du circuit intégré;
- les figures 3a et 3b représentent l'évolution du facteur KE en fonction du temps, selon le principe d'évaluation utilisé dans l'invention;
- la figure 4 est un synoptique d'une mémoire EEPROM;
- la figure 5 représente de façon détaillée une circuiterie de programmation de mémoire EEPROM, y compris pour déterminer et programmer une donnée d'étalonnage selon le procédé de l'invention;
- la figure 6 est un chronogramme des signaux de programmation, lors de la phase de détermination et programmation de la donnée d'étalonnage.
- la figure 7 représente un premier exemple de réalisation d'un dispositif permettant l'ajustement d'une durée; et
- la figure 8 représente un deuxième exemple de dispositif d'ajustement d'une durée.

Sur la figure 2a, on a représenté un organigramme d'un procédé d'ajustement d'une temporisation interne selon l'invention.

Un testeur émet un stimuli d'étalonnage ST vers un circuit intégré. Ce stimuli est détecté par le circuit intégré qui passe en mode d'étalonnage.

Dans l'exemple représenté, le testeur envoie ensuite une instruction INS1 du jeu d'instruction opérationnel du circuit intégré, cette instruction déclenchant la temporisation interne TEMP à ajuster.

Dans un exemple d'application du procédé d'ajustement à un circuit mémoire, pour ajuster la durée du signal de programmation, cette instruction sera une instruction d'écriture normale, d'une donnée quelconque à une adresse quelconque.

On peut prévoir que le passage en mode d'étalonnage déclenche directement la temporisation interne. Mais utiliser le jeu d'instructions du circuit intégré permet avantageusement de ne pas avoir à développer trop de codes programmes de test spécifiques dans le circuit intégré.

Le déclenchement de la temporisation autorise (En) la réception de données.

Le testeur connaît le moment du déclenchement de la temporisation interne dans le circuit intégré, à partir du moment où il a envoyé l'instruction INS1. A partir de ce moment, il envoie successivement les valeurs d'étalonnage, K1, K2..., en entrée du circuit intégré.

Chacune de ces valeurs est égale au rapport de la valeur typique T0 de la durée du signal de temporisation interne sur la durée écoulée au moment où elle est envoyée depuis le moment du déclenchement.

De préférence, le testeur envoie les valeurs d'étalonnage à la fréquence d'une horloge.

Si chaque valeur d'étalonnage est codée sur un octet et si 1/TK est la fréquence d'envoi des octets par le testeur, les valeurs d'étalonnage successivement envoyées depuis le déclenchement sont: K1=T0/TK ; K2=T0/2.TK ; ...; Kn= T0/n.TK.

Dans le cas où le circuit intégré suit un protocole série I2C de transmission de données, la période TK d'envoi des octets est égale à 9.Tck, où Tck est la période du signal d'horloge CK de la liaison série.

On notera que l'on pourrait très bien avoir une transmission série des données selon un autre protocole, tel que le protocole SPI ou Microware. On pourrait aussi avoir une transmission parallèle des données. L'invention n'est pas limité à un protocole de transmission des données.

La réception de données est désactivée (Des) dans le circuit intégré par l'expiration du signal de temporisation interne (FINTEMP). Le circuit intégré ne prend plus en compte aucune donnée présentée en entrée. On peut prévoir qu'il termine la réception de la donnée en cours de transmission (cas d'une transmission série).

Lorsque le signal de temporisation interne TEMP se termine (FINTEMP), la dernière valeur d'étalonnage envoyée, ou la valeur d'étalonnage en cours d'envoi (selon le circuit de gestion de réception de données) est la donnée d'étalonnage KE pour le circuit intégré considéré.

On note KE, la donnée d'étalonnage du circuit intégré déterminée selon le procédé de l'invention.

Cette donnée est ensuite mémorisée dans un élément de mémoire non volatile : ce peut être un fusible, un élément de mémoire EPROM ou EEPROM. Cette mémorisation peut être commandée par le testeur, comme représenté sur la figure 2a. Dans ce cas, le testeur émet une instruction INS2, correspondant de préférence à une instruction du jeu opérationnel du circuit intégré, pour programmer cette donnée. Dans un exemple d'application du procédé d'ajustement à la durée de programmation dans un circuit mémoire, cette instruction INS2 sera une instruction d'écriture de la donnée K(E) à une adresse particulière. L'adresse de programmation M(K_{E}) de la donnée d'étalonnage K(_{E})est de préférence déterminée en interne dans le circuit intégré. Ainsi, en opérationnel, il n'est pas possible de modifier la donnée d'étalonnage mémorisée dans le circuit intégré.

Le procédé d'ajustement est terminé. Le circuit intégré sort du mode d'étalonnage.

En mode de fonctionnement opérationnel du circuit intégré, l'élément de mémoire non volatile M(K_{E}) est lu et son contenu K_{E} appliqué en entrée d'au moins un dispositif d'ajustement d'une référence, prévu dans le circuit intégré. On peut prévoir que la lecture de l'élément de mémoire non volatile est effectuée dans la phase d'initialisation du circuit intégré, déclenchée par sa mise sous tension.

Les valeurs d'étalonnage envoyées par le testeur, sont contenues en pratique sous forme d'une table (par exemple dans une pile). Cette table est établie une fois pour toutes pour une technologie de fabrication donnée.

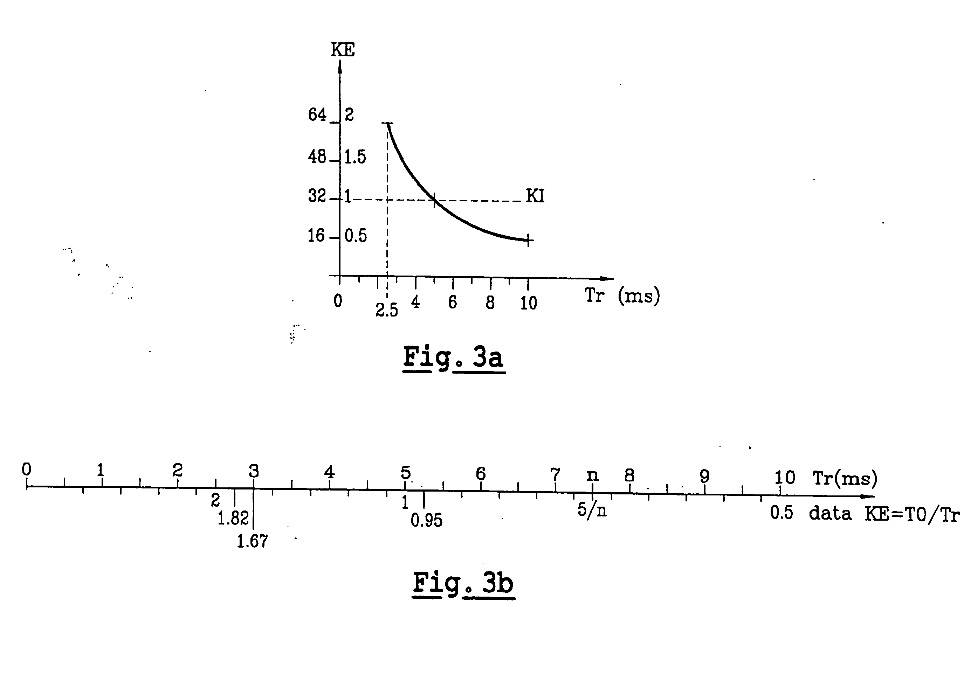

Les figures 3a et 3b montrent, pour une technologie de fabrication donnée, la variation du facteur de proportionnalité K_{E}=Tr/T0, dans le cas d'un signal de programmation. Dans l'exemple, la valeur typique T0 du signal de programmation est égale à 5 millisecondes. Les valeurs de K_{E} contenues dans la table du testeur correspondent en pratique à un échantillonnage à la fréquence d'horloge du testeur. Avec une fréquence horloge de 4Mhz, on prévoit que le testeur envoie une nouvelle valeur toutes les 0,25 millisecondes depuis le départ de la programmation, pendant la durée maximum de la programmation, typiquement 10 millisecondes. La table contient ainsi 40 valeurs de K_{E}.

On peut aussi prévoir que le testeur ne commence à envoyer une valeur qu'à partir d'une durée minimum, par exemple, 2,5 millisecondes (Fig.3a). En dessous de cette durée, le circuit intégré n'est pas ajusté et sera mis au rebut.

Dans l'exemple en relation avec les figures 3a et 3b, le testeur envoie alors à t=2,5ms, la première valeur K1=2=(5/2,5) ; à t=2,75 ms, la deuxième valeur K2=1.82=(5/2,75) ; ... etc jusqu'à t=10ms, la trente et unième valeur K31=0.5=(5/10). La table d'étalonnage du testeur comprend alors trente et une valeurs.

Chaque circuit intégré étalonné selon l'invention enregistre comme donnée d'étalonnage la valeur d'étalonnage qui correspond à la durée réelle de son impulsion de programmation.

Un testeur mettant en oeuvre le procédé d'ajustement selon l'invention comprendra alors typiquement, comme représenté sur la figure 2b, au moins un signal d'horloge CK, une table TAB de valeurs K1,..K40 de la donnée d'étalonnage K_{E} et un circuit de commande COM apte à lancer le mode d'étalonnage, déclencher la temporisation interne, contrôler l'envoi des valeurs d'étalonnage, et le cas échéant, commander la programmation de la donnée d'étalonnage.

Un circuit intégré auquel on veut appliquer le procédé d'ajustement selon l'invention, doit comprendre au moins un circuit de génération GEN-TEMP d'une temporisation interne TEMP, avec un dispositif AJUST d'ajustement de la durée associé, des moyens d'enregistrement temporaire REG, activés par le déclenchement de la temporisation interne, pour enregistrer les valeurs d'étalonnage reçues en entrée et désactivés après expiration de la temporisation (FINTEMP), et un élément de mémoire non volatile MEM(K_{E}) pour contenir la donnée d'étalonnage contenue dans les moyens d'enregistrement temporaire. La donnée contenue dans l'élément de mémoire non volatile est appliquée en entrée du dispositif d'ajustement AJUST.

En pratique, un circuit intégré comprend généralement un registre d'entrée de données. C'est notamment le cas des circuits intégrés à mémoire, et des circuits à transmission série. Il faut donc principalement prévoir de modifier la logique de contrôle CL du circuit intégré pour lui faire reconnaître le mode d'étalonnage et contrôler les différents éléments de façon appropriée. Il faut ensuite prévoir un dispositif d'ajustement de la référence. De tels dispositifs sont à la portée de l'homme de l'art et dépendent principalement du circuit de référence en cause et de sa structure.

Le dispositif d'ajustement agit sur une référence dont dépend la durée de la temporisation interne, par exemple, un courant de référence, ou la valeur d'une capacité.

Par extension, pour ajuster une référence quelconque dans le circuit intégré, par exemple une source de tension, ou une résistance, il suffit de convertir cette référence en un courant par exemple, puis d'utiliser ce courant pour générer une temporisation dont la durée sera fonction de ce courant. On peut alors appliquer le procédé d'ajustement à cette temporisation. La donnée d'étalonnage ainsi déterminée pourra être appliquée à un dispositif d'ajustement de la référence initiale, dans l'exemple, une tension ou une résistance.

L'invention va être plus particulièrement expliquée en prenant l'exemple d'une mémoire non volatile de type EEPROM, dans un circuit intégré à accès série.

Mais l'invention s'applique de façon générale à tout circuit intégré comprenant une référence à laquelle on peut faire correspondre une temporisation interne, et aussi bien aux circuits intégrés à accès série que parallèle.

Un synoptique général d'un circuit intégré à mémoire non volatile huit bits de type EEPROM à accès série, est représenté sur la figure 4.

Un tel circuit intégré comprend habituellement 8 broches externes b1 à b8, pas nécessairement toutes utilisées en opérationnel.

Dans un exemple, pour une interface série du type I2c, on a une broche b8 pour la tension d'alimentation Vdd ; une broche b4, pour la masse ; une broche b6 pour l'horloge CK (fil SDL du bus I2c), une broche b5 pour les données d'entrée et sortie (fil SDA du bus I2c).

Les autres broches b0, b1, b2 et b7 peuvent être utilisées à des fins de test en opérationnel. Notamment, on peut prévoir que le stimuli ST d'activation du mode d'étalonnage selon l'invention représenté comme un code sur trois bits soit appliqué sur les broches b0,b1,b2.

Le circuit intégré comprend de façon habituelle un circuit logique CL, pour contrôler les échanges de données en entrée et en sortie sur le bus externe, et gérer les signaux internes de commande.

Il comprend en outre un plan mémoire 1 de cellules mémoire non volatile, de décodeurs d'adresse de rangée DECX et de colonnes DECY permettant l'accès à une ou plusieurs cellules de la mémoire, un circuit 2 de génération de l'impulsion de programmation et un circuit 3 de lecture.

De tels circuits sont bien connus de l'homme du métier.

Pour permettre l'application d'un procédé d'ajustement de la durée d'une temporisation interne du circuit intégré selon l'invention, des moyens d'ajustement doivent être prévus, comme indiqué sur le synoptique de la figure 2b.

Dans le cas d'un circuit intégré à mémoire, pour l'étalonnage du signal de programmation de la mémoire non volatile, on peut avantageusement utiliser des ressources de la mémoire. Notamment la circuiterie de programmation comprend un registre d'entrée de donnée de programmation, qui reçoit la donnée ou les données à programmer transmises en entrée de données du circuit intégré. Ce registre est contrôlé par le circuit logique CL.

Ce registre de la circuiterie de programmation peut être avantageusement utilisé pour enregistrer les valeurs d'étalonnage envoyées par le testeur.

L'élément de mémoire non volatile pour mémoriser la donnée d'étalonnage K_{E} peut être pris dans le plan mémoire non volatile. Il est de préférence situé dans une zone d'adressage supplémentaire non accessible pour l'utilisateur.

Le circuit logique CL doit être modifié, pour contrôler de façon appropriée la réception de données en mode d'étalonnage. En effet, en mode de fonctionnement normal en écriture, quand le circuit logique CL a reçu une instruction de programmation d'une donnée à une adresse mémoire, il est désélectionné. Dans un exemple, il est désélectionné par le renvoi d'un signal de stop (protocole I2c - transition "0" vers "1" sur la ligne SDA sur le niveau haut d'une impulsion d'horloge). Dans un autre exemple, il est désélectionné par le signal de "chip select" (transmission parallèle, ou transmission série selon un protocole SPI). C'est la désélection qui lance la programmation. Le circuit intégré ne prend plus aucune donnée en entrée.

En mode page, par lequel on va écrire plusieurs octets en même temps sur une même rangée, à des adresses colonnes consécutives, le circuit intégré reçoit d'abord l'instruction de programmation, l'adresse de départ, les données, puis la désélection du circuit intégré lance la programmation.

Pour mettre en oeuvre le procédé d'ajustement selon l'invention, il faut d'abord déclencher une programmation, et après le déclenchement de la programmation, il faut que le circuit intégré puisse recevoir les valeurs d'étalonnage comme données d'entrée.

Selon l'invention, on prévoit un mode d'étalonnage, qui utilise la même logique de réception des données qu'en mode page, mais après le déclenchement de la programmation.

Ainsi, lorsque le circuit logique CL décode le stimuli ST, il passe en mode d'étalonnage. Dans ce mode, après réception d'une instruction de programmation (INS1), à une adresse quelconque ADXX, d'une donnée quelconque DXX, le circuit logique déclenche le signal de programmation PROG.

Il autorise alors l'enregistrement successif dans le registre d'entrée de donnée de programmation des valeurs d'étalonnage transmises.

La fin du signal de programmation stoppe cet enregistrement, soit immédiatement, pour garder comme valeur d'étalonnage du circuit intégré la dernière valeur reçue ou bien après la fin de la réception de la valeur d'étalonnage en cours de transmission. Le registre d'entrée (ou auxiliaire) contient alors la donnée d'étalonnage du signal de programmation PROGBIT du circuit intégré considéré.

Un procédé d'ajustement selon l'invention, appliqué à un tel circuit intégré permet donc d'ajuster la durée du signal de programmation des cellules du plan mémoire non volatile.

Après ajustement, la durée réelle Tr du signal de programmation PROGBIT est proche de la valeur typique T0 déterminée pour la technologie de fabrication correspondante (courbe du facteur K_{E} des figures 3a et 3b). La précision de l'ajustement dépend de la fréquence du signal d'horloge, c'est à dire du nombre de coups d'horloge émis pendant la durée de programmation.

Dans ce contexte, le procédé d'ajustement selon l'invention comprend pour le testeur les étapes principales suivantes :
- envoi sur l'entrée de données SDA d'une instruction de programmation, avec une adresse quelconque ADXX, et une donnée quelconque DXX;
- envoi en séquence sur l'entrée de données SDA du circuit intégré, des valeurs d'étalonnage Ki.

On peut en outre prévoir que le testeur envoie une instruction de programmation, pour programmer la donnée d'étalonnage K_{E} à une adresse réservée en mémoire non volatile.

De préférence, on prévoit une logique interne dans le circuit intégré pour lancer cette programmation.

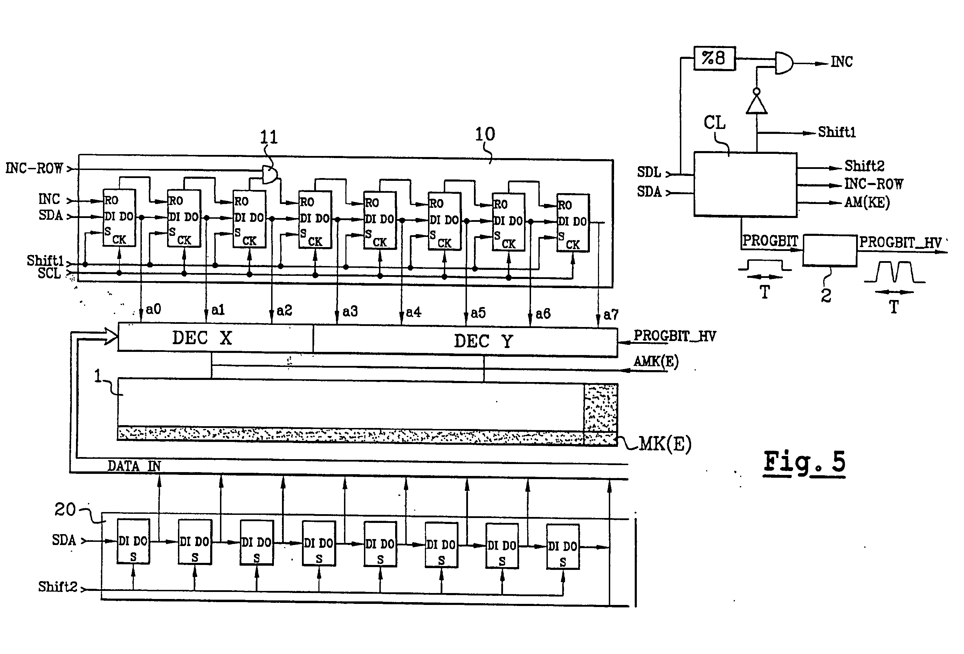

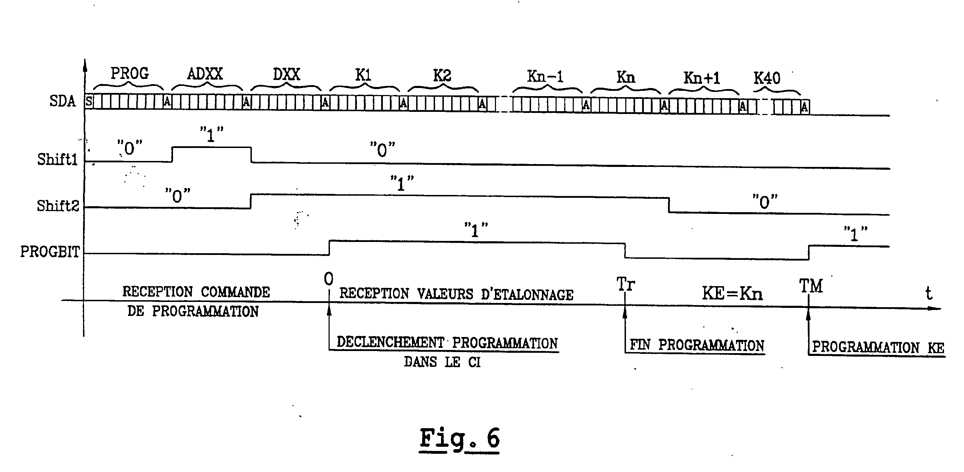

Le fonctionnement du circuit intégré en mode d'étalonnage est détaillé, en relation avec les figures 5 et 6.

La figure 5 représente une circuiterie de programmation d'une mémoire non volatile, dans un exemple de circuit intégré à accès série.

Cette circuiterie de programmation comprend de façon simplifiée, un registre d'adresse 10, du type registre à décalage à fonctionnement en compteur (gestion de mode page). Ce registre d'adresse reçoit en entrée de données, le signal SDA de l'interface série, le signal d'horloge SDL de l'interface série et un signal de validation du décalage Shift1, généré par le circuit logique de contrôle CL.

Dans l'exemple, les sorties a7-a3 de ce registre 10 forment l'adresse de rangée du mot mémoire à programmer, et sont appliquées en entrées du décodeur de rangée DECY. Les sorties a2-a0 de ce registre sont appliquées en entrées du décodeur de ligne de bit (DECX).

Le signal de validation Shiftl est activé pendant les huit coups d'horloge suivant la réception du code instruction PROG (FIG.6), pour enregistrer les huit bits d'adresse dans le registre 10.

Dans l'exemple, le registre d'adresse reçoit en outre des signaux de contrôle de mode page, INC et INC-ROW, avec une logique 11 associée. Ces signaux permettent l'incrémentation automatique de l'adresse de rangée en mode page (fonctionnement en compteur).

Le mode page est un mode de programmation bien connu par lequel on présente la première adresse, puis les données à programmer à partir de cette adresse. Le circuit CL fournit le signal d'incrémentation d'adresse colonne, INC, pour appliquer chaque nouvelle donnée de programmation aux latchs de la colonne associée.

Le signal INC-Row est un signal d'incrémentation de rangée, utilisé en lecture.

La circuiterie de programmation comprend aussi un registre 20 d'entrée de données de programmation, du type registre à décalage. Ce registre d'entrée de donnée de programmation reçoit en entrée de donnée, le signal SDA de l'interface série et un signal de commande d'enregistrement Shift2, généré par le circuit logique de contrôle CL.

Le circuit logique de contrôle CL est séquencé par le signal d'horloge CK.

En mode opérationnel, normal du circuit intégré, la programmation d'une donnée à une adresse de la mémoire se passe comme suit.

Le circuit est sélectionné pour un protocole série type I2C : (code de sélection reçu sur la ligne SDA et décodé par le circuit logique CL de la mémoire correspondant à une transition "1" vers "0" sur le niveau haut d'une impulsion d'horloge. Ce code ne correspondant pas à un bit de donnée sur la ligne SDA, il n'est pas représenté sur la figure 6). Une demande de programmation PROG est reçue.

Le circuit logique de contrôle CL active alors le signal de commande du registre d'adresse Shift1, pour permettre l'enregistrement des huit bits d'adresse transmis en série sur la ligne SDA. Après huit coups d'horloge, les huit bits d'adresse ADXX sont enregistrés, et appliqués en entrée des décodeurs DECX et DECY.

Le circuit logique de contrôle CL active ensuite le signal de commande Shift2 du registre de données, pour une durée correspondante à la réception de la donnée (soit huit coups d'horloge) pour enregistrer la donnée à programmer.

A la retombée du signal Shift2, le circuit logique de contrôle CL est désélectionné autrement dit, il ne prend plus en compte les données qu'il pourrait recevoir de l'interface série SDA. La désélection lance la programmation de la donnée contenue dans le registre 20 à l'adresse mémoire sélectionnée, en activant le signal PROGBIT. Ce signal est notamment appliqué à un circuit de génération 2 du signal de programmation (haute tension) PROGBIT, appliqué aux décodeurs.

En mode d'étalonnage selon l'invention, lorsque le circuit intégré reçoit une commande de programmation, le fonctionnement du circuit logique de contrôle est modifié, pour permettre l'enregistrement des valeurs d'étalonnage envoyées par le testeur, dans le registre de donnée 20, jusqu'à la fin du signal de programmation. La dernière valeur enregistrée est la donnée d'étalonnage KE, à programmer ensuite à une adresse réservée, prédéfinie dans le circuit intégré, de la mémoire non volatile. La modification tient notamment dans la génération du signal Shift2. En mode d'étalonnage, ce signal Shift2 ne retombe pas avant que la programmation soit lancée, mais seulement après la fin du signal de programmation PROGBIT. Tant qu'il est actif, le registre de donnée 20 continue de prendre en compte les bits appliqués en entrée SDA.

Ainsi, lorsque le circuit logique décode le stimuli ST appliqué dans l'exemple, sur les broches b0, b1, b2, il passe en mode d'étalonnage pour générer de façon appropriée le signal Shift2.

Le procédé d'ajustement consiste alors, comme représenté sur la figure 6 :
- à sélectionner le circuit intégré.
- à lancer une programmation à une adresse quelconque ADXX avec une donnée de programmation quelconque DXX;
- à envoyer en séquence les valeurs d'étalonnage (issues de la table du testeur) : K1, K2, ...Kn, Kn+1. Le début de l'envoi de ces données coïncide théoriquement avec le départ de la programmation (PROGBIT à 1).

Le signal Shift2 reste activé jusqu'à ce que le signal de programmation PROGBIT repasse à zéro.

Dans une première variante, représentée sur la figure 6, la retombée du signal Shift2 (à 0) est commandée par la fin de la programmation (PROGBIT à 0) et la réception des huit bits de données. En d'autres termes, Shift2 repasse à zéro au premier coup d'horloge multiple de huit après que PROGBIT soit retombé à 0. Dans cet exemple, en rapport avec la figure 6, c'est la valeur Kn qui est contenue dans le registre de donnée 20.

Dans une autre variante, la donnée d'étalonnage est la dernière valeur reçue. Dans ce cas, on prévoit un registre auxiliaire (non représenté) dans lequel on transfère, tous les huit coups d'horloge, le contenu du registre de donnée 20. Lorsque le signal PROGBIT de programmation retombe, le signal Shift2 est désactivé. La donnée d'étalonnage K_{E} est alors la valeur contenue dans le registre auxiliaire, Kn-1 dans l'exemple de la figure 6.

Toutes ces variantes sont aisées à implémenter et ne nécessitent que peu de logique supplémentaire dans le circuit logique de contrôle CL.

Côté testeur, comme il n'y a pas de retour d'information prévue (test en parallèle), on prévoit en pratique qu'il envoie systématiquement toutes les valeurs contenues dans sa table (soit par exemple, 40 valeurs).

Quand il a fini d'envoyer toutes les valeurs, il est certain que chaque circuit intégré contient la donnée d'étalonnage qui lui convient, soit dans le registre de données 20, soit dans un registre auxiliaire. Il peut donc lancer une opération de programmation de la donnée d'étalonnage K_{E} à une adresse réservée. Cette programmation suit le mode normal de programmation, à l'exception du fait que l'adresse est imposée en interne, par exemple, par un bit de forçage d'adresse AM(K_{E}) qui permet de sélectionner directement la colonne et la rangée correspondant à l'élément mémoire M(K_{E}) où la valeur K(_{E})doit être programmée (figure 5).

Dans une variante représentée sur le chronogramme de la figure 6, c'est le circuit intégré lui-même qui lance la programmation de la donnée d'étalonnage. En effet le circuit est capable de savoir quand la valeur de K_{E} est déterminée et contenue dans le registre de donnée par les signaux logiques qui vont bloquer cette valeur dans le registre de donnée (ou un registre auxiliaire) (notamment par la retombée du signal Shift2). Le circuit logique peut lancer dans La foulée la programmation de cette valeur.

Le procédé d'ajustement selon l'invention appliqué à un circuit intégré à mémoire nécessite donc des modifications mineures à la portée de l'homme de l'art.

Il est compatible avec un test de circuits en parallèle.

Le procédé d'ajustement selon l'invention ne se limite pas à des applications à des circuits intégrés à transmission série de données, selon un protocole I2c. Il est généralement applicable à tous circuits intégrés et à tout type de protocole de transmission de données. Notamment, dans le cas d'un protocole de transmission parallèle, chaque nouvelle valeur d'étalonnage est présentée par le testeur avec une nouvelle adresse. Le circuit de détection de transition d'adresse du circuit intégré détecte chaque changement d'adresse et provoque l'enregistrement de la valeur d'étalonnage associée dans un registre d'entrée.

La donnée d'étalonnage K_{E} déterminée selon le procédé de l'invention et mémorisée dans un élément de mémoire non volatile MEM(K_{E}) doit être appliquée à au moins un dispositif d'ajustement associé, pour activer un nombre correspondant de branches d'ajustement. En pratique, la donnée d'étalonnage K_{E} est codée sous forme d'un octet. Sur la figure 3a, on a ainsi donné un exemple de codage binaire des valeurs de K_{E}.

Dans cet exemple,
à K_{E} = 2 on fait correspondre 64 dans la table des valeurs d'étalonnage;
à K_{E} = 1,5 on fait correspondre 48
à K_{E} = 1, on fait correspondre 32
et à K_{E} = 0,5 on fait comprendre 16.

La valeur d'étalonnage K_{E} déterminée par le procédé d'ajustement est mémorisée dans un élément de mémoire non volatile M(K_{E}). On prévoit qu'à la mise sous-tension du circuit intégré, une opération de lecture de cet élément mémoire permet de positionner un registre d'entrée R(K_{E}) du dispositif d'ajustement.

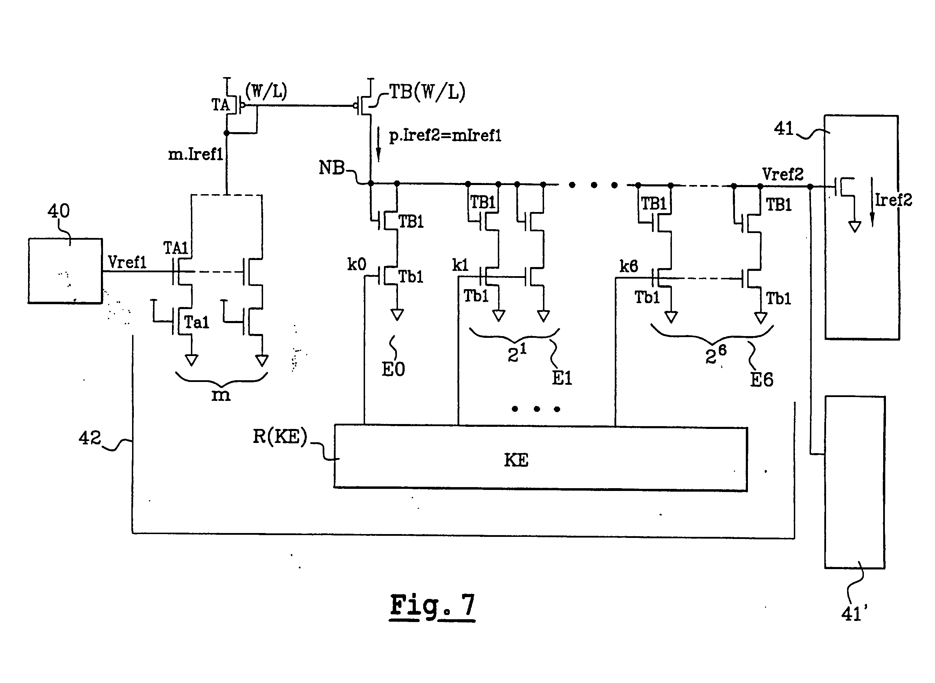

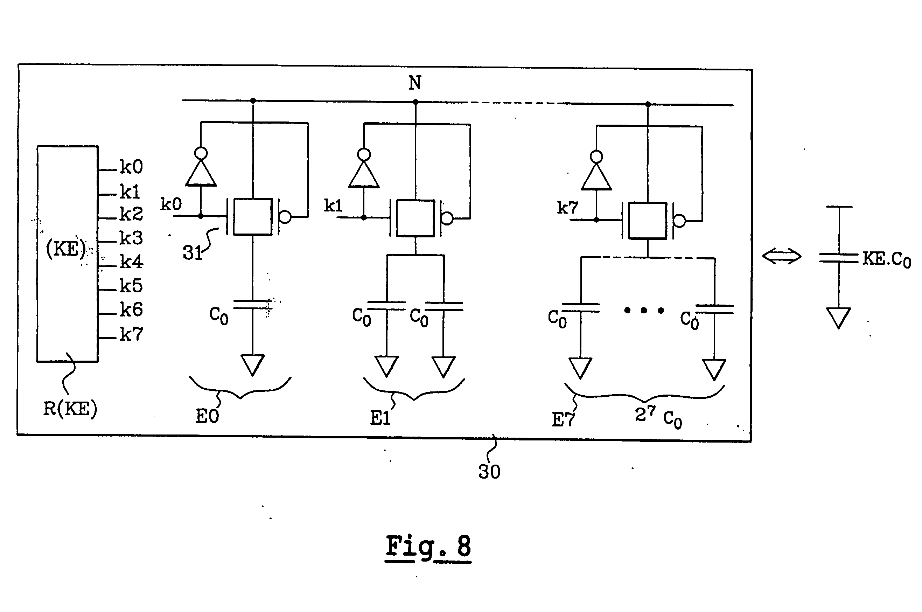

Sur les figures 7 et 8, on a représenté deux exemples de réalisation d'un dispositif d'ajustement d'une référence.

Le premier exemple de réalisation, figure 7, permet d'ajuster une intensité de courant de référence, par exemple le courant de charge et décharge d'un condensateur (non représenté).

Dans l'exemple la source de courant 40 à ajuster fournit en sortie une tension Vref1. Cette tension devrait être appliquée dans un circuit 41 à miroir de courant pour commander un courant de référence Iref1 dans ce circuit.

Selon l'invention, un dispositif d'ajustement 42 du courant Iref1 est placé entre la sortie de la source de tension et l'entrée du circuit 41.

Ce dispositif d'ajustement comprend un registre R(KE), initialisé avec la donnée d'étalonnage K_{E}. Si dans un exemple pratique, pour la valeur maximum de K_{E}, 2 dans l'exemple (figure 3a), le registre R(KE) est initialisé à 64, 7 bits de codage sont nécessaires : k0 à k6. Dans ce cas 7 étages d'ajustement sont prévus, permettant de mettre de 1 à 127 branches d'ajustement en service, selon la valeur de K_{E}.

Le dispositif d'ajustement représenté sur la figure 7 est basé sur une structure à miroir de courant, pour fournir en sortie une tension de référence Vref2. De cette façon, on va commander un courant ajusté Iref2, au lieu de Iref1, dans le circuit 41, avec Iref2 égal à K_{E}.Iref1.

Dans l'exemple, la structure à miroir de courant du dispositif d'ajustement 42 de courant comprend deux branches, à transistors MOS.

Une première branche comprend un transistor TA monté en diode , connecté entre la tension d'alimentation Vdd et un noeud NA, et m étages en parallèle, connectés chacun entre le noeud NA et la masse et commandés par la tension de référence Vref1. Chacun de ces étages comprend un premier transistor TA1 connecté au noeud NA, et en série avec un deuxième transistor Ta1, qui est lui connecté à la masse. Le transistor TA1 est commandé sur sa grille par la tension Vref1, et le transistor Ta1 est toujours passant (grille à Vcc dans l'exemple). Chaque étage (TA1, Ta1) appelle donc un courant Iref1, en sorte que l'on retrouve un courant m.Iref1 dans le transistor TA.

La deuxième branche comprend un transistor TB connecté en diode, entre la tension d'alimentation Vdd et un noeud NB et six étages d'ajustement E0 à E6, un par bit de codage de la donnée d'étalonnage K_{E}.

L'étage E0 de rang 0, comprend une branche d'ajustement commandée par le bit k0 de la donnée d'étalonnage K_{E}. L'étage E6 de rang 6 comprend 64 branches d'ajustement en parallèle, commandées par le bit k6 de la donnée d'étalonnage K_{E}.

Chaque branche d'ajustement comprend un transistor TB1 connecté au noeud NB, en série avec un autre transistor Tb1 connecté à la masse. Le transistor TB1 est monté en diode. Le transistor Tb1 est commandé par le bit correspondant de la donnée d'étalonnage K_{E}.

Ainsi l'étage Ei de rang i comprend 2ⁱ branches d'ajustement (TB1, Tb1), toutes commandées par le bit ki de rang i de la donnée d'étalonnage K_{E}.

Ainsi, en fonction du nombre de branches d'ajustement mises en service par la donnée d'étalonnage K_{E}, on obtient au noeud B une tension de référence Vref2, par laquelle on commande un courant Iref2 égal à Irefl/K_{E} dans le circuit 41. Si p est le nombre de branches mises en service par la donnée K_{E}, on a en effet un courant p.Iref2 dans le transistor TB, qui, par l'effet miroir de courant TA/TB, est égal à m.Irefl. Soit Iref2=m/pIref1.

Les m étages commandés par Vref1 sont nécessaires pour couvrir tous les cas de K_{E}. Si K_{E} est supérieur à 1, il faut en effet baisser le courant, mais si K_{E} est inférieur à 1, il faut au contraire augmenter le courant. Dans le premier cas, on aura m>p et dans l'autre, p>m.

Le dispositif d'ajustement correspondant à la figure 8, permet d'ajuster la capacité d'un condensateur C selon sensiblement le même principe : les bits de donnée K_{E} permettent de mettre plus ou moins de condensateurs en parallèle.

Dans l'exemple de l'étalonnage du signal de programmation, le condensateur à ajuster est chargé et déchargé par un courant de référence, pour fournir en sortie un signal de durée calibrée.

Le dispositif d'ajustement 30 comprend n étages, un par bit ki de la donnée d'étalonnage K_{E}.

Ces étages du dispositif d'ajustement sont connectés en parallèle entre un noeud N et la masse.

Si Cinit est la capacité réelle du condensateur à ajuster, le dispositif d'ajustement permet d'obtenir, une capacité équivalente à K_{E}.Cinit.

L'étage de rang 0, E0 comprend un condensateur d'ajustement Ca, et un circuit 31 de type pass-gate, commandé par le bit k0 de la donnée d'étalonnage K_{E}.

L'étage de rang i, Ei, comprend 2ⁱ condensateurs d'ajustement Ca en parallèle, et une porte de transfert 31 de type pass-gate commandée par le bit ki de la donnée d'étalonnage K_{E}.

La donnée d'étalonnage K_{E} commande ainsi la mise en parallèle effective de K_{E} condensateurs C0. On obtient une capacité équivalente à K_{E}.C0.

En pratique, on notera que les dispositifs d'ajustement sont inclus dans le circuit intégré. Il faut donc que le registre R(K_{E}) soit pré-initialisé pour connecter au moins une branche d'ajustement. On sait positionner un registre à une valeur voulue, par exemple au moyen d'une logique appropriée. On note K_{I}, cette valeur d'initialisation. Alors, la valeur d'étalonnage K_{E} mesurée selon l'invention et à appliquer au dispositif d'ajustement doit être en fait K_{E}.K_{I}. En pratique, tous les circuits intégrés ont leur registre R(K_{E}) pré-initialisés à la même valeur K_{I}. Il suffit donc d'appliquer le facteur K_{I} aux valeurs de la table d'étalonnage contenues dans le testeur.

En outre, si on pré-initialise le registre R(K_{E}) à la valeur moyenne 32 correspondant à K_{E} = 1, comme représenté sur la figure 3a, la dynamique de codage est en pratique inchangée.

Si l'on initialise à une autre valeur, cela revient à décaler les valeurs de K_{E} vers le haut (K_{I}>1) ou vers le bas (K_{I}<1).

D'autres réalisations de dispositifs d'ajustement sont possibles, en fonction notamment de. la structure du circuit de référence à ajuster.

Si la référence ajustée est appliquée dans différents circuits du circuit intégré, par exemple, comme représenté sur la figure 7, si le circuit de référence de courant 40 est appliqué à deux circuits différents 41 et 41', l'ajustement s'applique aux deux circuits 41 et 41'.

En outre, comme la dispersion des caractéristiques liées au procédé de fabrication agit de la même façon, au premier ordre, sur tous les éléments du circuit intégré, on peut appliquer la donnée d'équilibrage à plusieurs dispositifs d'ajustement du même type de référence. Par exemple, on peut prévoir d'ajuster ainsi plusieurs sources de référence de courant. Le dispositif d'ajustement est le même pour chacune.

Un seul étalonnage est nécessaire basé sur une temporisation interne reliée à une des références en question, et la donnée d'étalonnage s'applique à toutes ces sources.

L'invention qui vient d'être décrite peut être appliquée pour étalonner différent types de références dans un circuit intégré, pourvues qu'elles soient reliées à une temporisation interne que l'on sait activer en externe, comme le signal de programmation.

Il permet d'améliorer les caractéristiques des circuits intégrés, avec un étalonnage proche des valeurs typiques, ce qui améliore leur fiabilité en opérationnel et de réduire le nombre de circuits intégrés à mettre au rebut.

En outre il permet d'étalonner en aveugle des circuits intégrés en parallèle, puisque c'est chaque circuit qui détermine sa propre sa propre valeur d'étalonnage, le testeur se contentant de déclencher la temporisation interne voulue et d'envoyer la suite de valeurs d'étalonnage.

## Revendications

1. Procédé d'ajustement de la durée d'une temporisation interne, à une valeur proche d'une valeur typique (T0) de cette durée, **caractérisé en ce qu**'il consiste à déclencher ladite temporisation interne (TEMP) dans ledit circuit intégré et à envoyer séquentiellement des valeurs d'étalonnage (K1, K2) en entrée dudit circuit intégré, l'expiration de la temporisation interne déterminant comme donnée d'étalonnage (K_{E}) dudit circuit intégré, la dernière valeur d'étalonnage reçue ou celle en train d'être reçue, ladite donnée d'étalonnage étant appliquée à un dispositif d'ajustement (AJUST) de la durée de la dite temporisation interne.

2. Procédé d'ajustement selon la revendication 1, **caractérisé en ce que** chaque valeur d'étalonnage correspond au rapport de la valeur typique (T0) sur la durée totale écoulée depuis le départ de la temporisation interne jusqu'au moment où cette valeur est envoyée.

3. Procédé d'ajustement selon la revendication 2, **caractérisé en ce que** le dispositif d'ajustement est pré-initialisé à une valeur d'initialisation (K_{I}).

4. Procédé d'ajustement selon la revendication 3, chaque valeur d'étalonnage envoyée est affectée d'un facteur correspondant à ladite valeur d'initialisation.

5. Procédé d'ajustement selon l'une quelconque des revendications précédentes, **caractérisé en ce que** la première valeur d'étalonnage est envoyée après écoulement d'une durée minimum (dm) de la temporisation interne.

6. Procédé d'ajustement selon l'une quelconque des revendications précédentes, ladite temporisation interne (TEMP) étant fonction d'au moins une référence fournie par un circuit de référence, **caractérisé en ce que** le dispositif d'ajustement (AJUST) est appliqué au dit circuit de référence.

7. Procédé d'ajustement d'une référence (Iref) dans un circuit intégré, **caractérisé en ce qu'**il consiste à prévoir, dans ledit circuit intégré, un dispositif d'ajustement (AJUST) de ladite référence à partir d'une donnée d'étalonnage (K_{E}) et un circuit de génération (GEN-TEMP) d'une temporisation interne (TEMP) à partir de ladite référence (Iref), et à appliquer un procédé d'ajustement de la durée selon l'une des revendications 1 à 4 à la temporisation interne (TEMP) ainsi générée, pour obtenir la donnée d'étalonnage (K_{E}) à appliquer au dispositif d'ajustement de la dite référence (Iref).

8. Procédé d'ajustement d'une référence selon la revendication 7, **caractérisé en ce que** le circuit de référence ajusté est une source de courant (Iref1).

9. Procédé d'ajustement selon la revendication 7, **caractérisé en ce que** le circuit de référence ajusté est un condensateur (Cref) ou réseau de condensateurs.

10. Procédé d'ajustement d'une référence selon l'une quelconque des revendications 7 à 9, **caractérisé en ce que** la donnée d'étalonnage (KE) est appliquée à un dispositif d'ajustement (AJUST1) d'un autre circuit de référence, ayant une structure identique qu'un circuit de référence associé à ladite temporisation interne (TEMP) .

11. Procédé d'ajustement d'une durée selon l'une des revendications 1 à 6 précédentes, **caractérisé en ce qu**'il est appliqué à un circuit intégré à mémoire non volatile, pour ajuster la durée d'un signal de programmation (PROG) de ladite mémoire.

12. Procédé d'ajustement selon la revendication 11, **caractérisé en ce qu**'il comprend :
- le lancement d'une programmation d'une donnée quelconque (DXX) à une adresse quelconque (ADXX) dans le circuit intégré;
- l'envoi successif en entrée de donnée des valeurs d'étalonnage du circuit intégré,
la fin de la programmation de la donnée quelconque (DXX) déterminant comme donnée d'étalonnage (K_{E}), la dernière valeur d'étalonnage (Kn-1) reçue ou la valeur d'étalonnage (Kn) en train d'être reçue par le circuit intégré.

13. Procédé d'ajustement selon la revendication 12, **caractérisé en ce qu**'il consiste, après l'envoi de toutes les valeurs d'étalonnage définies pour ladite temporisation interne en fonction des spécifications du circuit intégré, à lancer une programmation dans le circuit intégré, pour programmer la donnée d'étalonnage (KE).

14. Procédé d'ajustement selon la revendication 12 ou 13, **caractérisé en ce que** la donnée d'étalonnage est programmée à une adresse mémoire (M(KE)) déterminée en interne du circuit intégré.

15. Procédé d'ajustement selon la revendication 13 ou 14, **caractérisé en ce qu'**il consiste pour le circuit intégré à lancer en interne la programmation de la donnée d'étalonnage (K_{E}).

16. Procédé d'ajustement selon la revendication 13 ou 14, **caractérisé en ce que** le circuit intégré reçoit une commande programmation de la donnée d'étalonnage.

17. Procédé d'ajustement selon l'une quelconque des revendications 11 à 16, **caractérisé en ce que** les valeurs d'étalonnage sont enregistrées dans un registre d'entrée de données du circuit intégré.

18. Circuit intégré **caractérisé en ce qu**'il comprend un circuit de génération d'une temporisation interne (TEMP) à partir d'au moins une référence, et des moyens d'ajustement de ladite référence, 'lesdits moyens d'ajustement comprenant des moyens d'enregistrement temporaire (REG) pour enregistrer des données (K_{I}) envoyées sur une entrée de données du circuit intégré après un déclenchement de ladite temporisation interne, un élément de mémoire non volatile (MEM(K_{E})) pour mémoriser la donnée (K_{E}) contenue par lesdits moyens de mémorisation temporaire (REG) à l'expiration de ladite temporisation interne et au moins un dispositif d'ajustement (AJUST) d'un circuit de génération de ladite référence, la donnée contenue dans ledit élément de mémoire non volatile étant appliquée en entrée dudit dispositif d'ajustement.

19. Circuit intégré selon la revendication 18, **caractérisé en ce qu**'il comprend un ou plusieurs circuits de référence associés au circuit de génération de la temporisation interne, un premier dispositif d'ajustement d'un desdits circuits de référence associés au circuit de génération de la temporisation interne et au moins un deuxième dispositif d'ajustement d'un autre circuit de référence non associé au circuit de génération de la temporisation interne, cet autre circuit de référence ayant une structure identique à l'un des circuits de référence associés au circuit de génération de la temporisation interne et la donnée contenue dans l'élément de mémoire non volatile étant appliquée aux dits premier et deuxième dispositifs d'ajustement.

20. Circuit intégré selon la revendication 18 ou 19 comprenant une mémoire non volatile, **caractérisé en ce que** le signal de temporisation interne est le signal de programmation (PROG) de cette mémoire et **en ce que** les moyens de mémorisation temporaire comprennent un registre d'entrée de donnée.

21. Circuit intégré selon l'une des revendications 18 à 20, **caractérisé en ce qu'**un dispositif d'ajustement est appliqué à un circuit de référence de courant.

22. Circuit intégré selon l'une des revendications 18 à 20, **caractérisé en ce qu**'un dispositif d'ajustement est appliqué à un circuit de référence de type condensateur ou réseau de condensateurs.

23. Circuit intégré selon l'une des revendications 18 à 20, **caractérisé en ce qu**'un dispositif d'ajustement est appliqué à un circuit de référence de type résistance ou réseau de résistances.

24. Système de test en parallèle de circuits intégrés d'une même technologie, **caractérisé en ce que** ledit système comprend une table (TAB) de valeurs d'étalonnage d'une temporisation interne desdits circuits intégrés pour ajuster la temporisation interne ou au moins une référence associée dans chacun desdits circuits intégrés, en leur appliquant simultanément un procédé d'ajustement selon l'une quelconque des revendications 1 à 17.

## Claims

1. A method for the adjustment of a duration of an internal dwell time with a value close to a typical value (T0) of this duration, **characterized in that** said method consists of the activation of said internal dwell time (TEMP) in said integrated circuit and of the sequential sending of dwell time calibration values (K1, K2) as inputs of said integrated circuit, the expiry of the internal dwell time determining, as calibration datum (KE) of said integrated circuit, the last calibration value received or the one that is being received, said calibration datum being applied to a device (AJUST) for adjusting the duration of said internal dwell time.

2. An adjustment method according to claim 1, **characterized in that** each calibration value corresponds to the ratio of the typical value (T0) to the total duration that has elapsed from the start of the internal dwell time to the time when this value is sent.

3. An adjustment method according to claim 2, **characterized in that** the adjustment device is pre-initialized at an initialization value (KI).

4. An adjustment method according to claim 3, **characterized in that** to each calibration value sent is assigned a factor corresponding to said initialization value.

5. An adjustment method according to any one of the above claims, **characterized in that** the first calibration value is sent after a minimum duration (dm) of the internal dwell time has elapsed.

6. An adjustment method according to any one of the above claims, said internal dwell time (TEMP) being a function of at least one reference given by a reference circuit, **characterized in that** the adjustment device (AJUST) is applied to said reference circuit.

7. A method for the adjustment of a reference (Iref) in an integrated circuit, **characterized in that** said method consists in providing, in said integrated circuit, a device (AJUST) for the adjustment of said reference on the basis of a calibration datum (KE) and a circuit (GEN-TEMP) for the generation of an internal dwell time (TEMP) from said reference (Iref) and in applying a method of adjustment of the duration according to one of claims 1 to 4 to the internal dwell time (TEMP) thus generated, so as to obtain the calibration datum (KE) to be applied to the device for adjusting said reference (Iref).

8. A method for the adjustment of a reference according to claim 7, **characterized in that** the adjusted reference circuit is a current source(Iref 1).

9. An adjustment method according to claim 7, **characterized in that** the adjusted reference circuit is a capacitor (Cref) or a capacitor network.

10. A method for the adjustment of a reference according to any one of claims 7 to 9, **characterized in that** the calibration datum (KE) is applied to an adjustment device (AJUST) of another reference circuit having a structure identical to that of a reference circuit associated with said internal dwell time (TEMP).

11. A method for the adjustment of a duration according to any one of the above claims 1 to 6, **characterized in that** it is applied to a non-volatile memory integrated circuit to adjust the duration of a signal (PROG) for the programming of said memory.

12. An adjustment method according to claim 11, **characterized in that** it comprises:
- the launching of an operation of programming any datum (DXX) at any address (ADXX) in the integrated circuit;
- the successive sending, as data inputs, of the calibration values of the integrated circuit,
the end of the programming of said any datum (DXX) determining as calibration datum (KE) the last calibration value (Kn-1) received or the calibration value (Kn) that is being received by the integrated circuit.

13. An adjustment method according to claim 12, **characterized in that** it consists, after sending all the calibration values defined for said internal dwell time as a function of the specifications of the integrated circuit, in launching a programming operation in the integrated circuit to program the calibration datum (KE).

14. An adjustment method according to claim 12 or 13, **characterized in that** the calibration datum is programmed at a memory address (M(KE)) determined internally to the integrated circuit.

15. An adjustment method according to claim 13 or 14, **characterized in that** it consists for the integrated circuit, in internally launching the programming of the calibration datum (KE).

16. An adjustment method according to claim 13 or 14, **characterized in that** the integrated circuit receives a command for programming the calibration datum.

17. An adjustment method according to any one of claims 11 to 16, **characterized in that** the calibration values are recorded in a data input register of the integrated circuit.

18. An integrated circuit, **characterized in that** it comprises a circuit for the generation of an internal dwell time (TEMP) from at least one reference and means for adjusting said reference, said adjustment means comprising temporary recording means (REG) for recording data (K1) sent to a data input of the integrated circuit after an activation of said internal dwell time, a non-volatile memory element (MEM(KE)) to store the datum (KE) contained in said temporary storage means (REG) on the expiry of said internal dwell time and at least one adjustment device (AJUST) for the adjustment of a circuit for the generation of said reference, the datum contained in said non-volatile memory element being applied as input to said adjustment device.

19. An integrated circuit according to claim 18, **characterized in that** it comprises one or more reference circuits associated with the internal dwell time generation circuit, a first device for the adjustment of one of said reference circuits associated with the internal dwell time generation circuit and at least one second device for the adjustment of another reference circuit not associated with the internal dwell time generation circuit, this other reference circuit having a structure identical to that of one of the reference circuits associated with the internal dwell time generation circuit and the datum contained in the non-volatile memory element being applied to said first and second adjustment devices.

20. An integrated circuit according to claim 18 or 19 comprising a non-volatile memory, **characterized in that** the internal dwell time signal is the programming signal (PROG) of this memory and **in that** the temporary storage means comprise a data input register.

21. An integrated circuit according to any one of claims 18 to 20, **characterized in that** an adjustment device is applied to a current reference circuit.

22. An integrated circuit according to any one of claims 18 to 20, **characterized in that** an adjustment device is applied to a reference circuit of capacitor or capacitor network type.

23. An integrated circuit according to any one of claims 18 to 20, **characterized in that** an adjustment device is applied to a reference circuit of resistor or resistor network type.

24. A system for the parallel testing of integrated circuits of one and the same technology, **characterized in that** said system comprises a table (TAB) of calibration values of an internal dwell time of said integrated circuits to adjust the internal dwell time or at least one associated reference in each of said integrated circuits, by simultaneously applying to them an adjustment method according to any one of claims 1 to 17.

## Patentansprüche

1. Verfahren zum Einstellen der Dauer eines Taktsignals auf einen Wert nahe eines typischen Wertes (T0) dieser Dauer, **dadurch gekennzeichnet, dass** dieses darin besteht, das Taktsignal (TEMP) in dem integrierten Schaltkreis auszulösen und beim Einsatz des integrierten Schaltkreises sequentiell Eichwerte (K1, K2) zu senden,
wobei der Ablauf des Zeittaktes den letzten empfangenen Eichwert oder den gerade empfangenen als Eichgröße (KE) des integrierten Schaltkreises bestimmt, wobei die Eichgröße an einer Einstelleinrichtung (AJUST) der Dauer dieses Zeittaktes angewendet wird.

2. Einstellverfahren nach Anspruch 1, **dadurch gekennzeichnet, dass** jeder Eichwert dem typischen Wert (T0) über die gesamte Dauer entspricht, die seit dem Beginn des Zeittaktes bis zu dem Augenblick, in welchem dieser Wert gesendet wird, vergeht.

3. Einstellverfahren nach Anspruch 2, **dadurch gekennzeichnet, dass** die Einstelleinrichtung auf einen Initialisierungswert (KI) vorinitialisiert wird.

4. Einstellverfahren nach Anspruch 3, **dadurch gekennzeichnet, dass** jeder gesendete Eichwert mit einem Faktor versehen wird, der dem Initialisierungswert entspricht.

5. Einstellverfahren nach einem der vorhergehenden Ansprüche, **dadurch gekennzeichnet, dass** der erste Eichwert nach Ablauf einer minimalen Zeitdauer (dm) des Zeittaktes gesendet wird.

6. Einstellverfahren nach einem der vorhergehenden Ansprüche, wobei der Zeittakt (TEMP) abhängig ist von wenigstens einem Bezugswert, der durch eine Bezugsschaltung geliefert wird, **dadurch gekennzeichnet, dass** die Einstelleinrichtung (AJUST) auf die Bezugschaltung angewendet wird.

7. Einstellverfahren eines Bezugswertes (Iref) in einem integrierten Schaltkreis, **dadurch gekennzeichnet, dass** dieses darin besteht, in der integrierten Schaltung eine Einstelleinrichtung (AJUST) für den Bezugswert vorzusehen, ausgehend von einer Eichgröße (KE) und einer Generierungsschaltung (GEN-TEMP) für einen Zeittakt (TEMP) ausgehend von dem Bezugswert (Iref), und darin, ein Einstellverfahren für die Zeitdauer nach einem der Ansprüche 1 bis 4 auf den so generierten Zeittakt (TEMP) anzuwenden, um die Eichgröße (KE) zu erhalten, die auf die Einstelleinrichtung für die Bezugsgröße (Iref) anzuwenden ist.

8. Einstellverfahren für eine Bezugsgröße nach Anspruch 7, **dadurch gekennzeichnet, dass** die eingestellte Bezugsschaltung eine Stromquelle (Irefl) ist.

9. Einstellverfahren nach Anspruch 7, **dadurch gekennzeichnet, dass** die eingestellte Bezugsschaltung ein Kondensator (Cref) oder ein Kondensatornetzwerk ist.

10. Einstellverfahren für eine Bezugsgröße nach einem der Ansprüche 7 bis 9, **dadurch gekennzeichnet, dass** die Eichgröße (KE) auf eine Einstelleinrichtung (AJUST1) einer weiteren Bezugsschaltung angewendet wird, die eine identische Struktur mit der Bezugsschaltung mit dem Zeittakt (TEMP) hat.

11. Einstellverfahren für eine Zeitdauer nach einem der vorhergehenden Ansprüche 1 bis 6, **dadurch gekennzeichnet, dass** diese auf eine integrierte Schaltung mit flüchtigem Speicher angewendet wird, um die Dauer eines Programmsignals (PROG) des Speichers einzustellen.

12. Einstellverfahren nach Anspruch 11, **dadurch gekennzeichnet, dass** dieses umfasst:
- die Freigabe einer Programmierung einer beliebigen Größe (DXX) mit einer beliebigen Adresse (ADXX) in der integrierten Schaltung;
- beim Einsatz nacheinander Senden einer Datengröße von Eichwerten der integrierten Schaltung,
wobei das Ende der Programmierung der beliebigen Datengröße (DXX) den letzten empfangenen Eichwert (Kn-1) oder den Eichwert (Kn), der gerade durch die integrierte Schaltung empfangen wird als Eichgröße (KE) festlegt.

13. Einstellverfahren nach Anspruch 12, **dadurch gekennzeichnet, dass** dieses darin besteht, nach dem Übertragen aller für den Zeittakt in Abhängigkeit von Spezifikationen der integrierten Schaltung definierten Eichwerte eine Programmierung in der integrierten Schaltung veranlasst wird, um den Eichwert (KE) zu programmieren.

14. Einstellverfahren nach Anspruch 12 oder 13, **dadurch gekennzeichnet, dass** der Eichwert an einer Speicheradresse (M (KE)) programmiert wird, die innerhalb der integrierten Schaltung bestimmt wird.

15. Einstellverfahren nach Anspruch 13 oder 14, **dadurch gekennzeichnet, dass** dieses für die integrierte Schaltung darin besteht, intern die Programmierung der Eichgröße (KE) zu veranlassen.

16. Einstellverfahren nach Anspruch 13 oder 14, **dadurch gekennzeichnet, dass** die integrierte Schaltung einen Programmierbefehl für die Eichgröße empfängt.

17. Einstellverfahren nach einem der Ansprüche 11 bis 16, **dadurch gekennzeichnet, dass** die Eichwerte in einem Eingangs-Datenregister der integrierten Schaltung eingetragen sind.

18. Integrierte Schaltung, **dadurch gekennzeichnet, dass** diese umfasst eine Erzeugerschaltung für ein Taktsignal (TEMP) ausgehend von wenigstens einer Bezugsgröße und eine Einstelleinrichtung für die Bezugsgröße, wobei die Einstelleinrichtung ein temporäres Register (REG) umfasst, um Daten (KI) zu registrieren, die über einen Dateneingang der integrierten Schaltung nach einer Auslösung des Zeittaktes gesendet werden, ein nicht flüchtiges Speicherelement (MEM (KE)), um die durch das temporäre Register (REG) gehaltene Datengröße (KE) bei Ablauf des Zeittaktes zu speichern, und wenigstens eine Einstelleinrichtung (AJUST) einer Erzeugerschaltung für die Bezugsgröße, wobei der in dem nicht flüchtigen Speicherelement gehaltene Datenwert beim Einsatz der Einstelleinrichtung angewendet wird.

19. Integrierte Schaltung nach Anspruch 18, **dadurch gekennzeichnet, dass** diese umfasst ein oder mehrere Bezugsschaltungen, die der Erzeugerschaltung für den Zeittakt zugeordnet sind, wobei eine erste Einstelleinrichtung einer der Bezugsschaltungen, die der Erzeugerschaltung des Zeittaktes zugeordnet sind und wenigstens eine zweite Einstelleinrichtung einer weiteren Bezugsschaltung, die der Erzeugerschaltung des Zeittaktes nicht zugeordnet ist, wobei diese weitere Bezugsschaltung eine mit den der Erzeugerschaltung des Zeittaktes zugehörigen Bezugsschaltungen identische Struktur hat und die in dem nicht flüchtigen Speicherelement gehaltene Datengröße an die erste und zweite Einstelleinrichtung angelegt wird.

20. Integrierte Schaltung nach Anspruch 18 oder 19, mit einem nicht flüchtigen Speicher, **dadurch gekennzeichnet, dass** das Taktsignal das Programmiersignal (PROG) dieses Speichers ist und dass die temporäre Speichereinrichtung ein Dateneingangsregister umfasst.

21. Integrierte Schaltung nach einem der Ansprüche 18 bis 20, **dadurch gekennzeichnet, dass** die Einstelleinrichtung auf eine Strom-Bezugsschaltung angewendet wird.

22. Integrierte Schaltung nach einem der Ansprüche 18 bis 20, **dadurch gekennzeichnet, dass** eine Einstelleinrichtung auf eine Kondensator- oder Kondensatornetz-Bezugsschaltung angewendet wird.

23. Integrierte Schaltung nach einem der Ansprüche 18 bis 20, **dadurch gekennzeichnet, dass** eine Einstelleinrichtung auf eine Widerstand- oder Widerstandsnetz-Bezugsschaltung angewendet wird.

24. Parallel arbeitendes Testsystem für integrierte Schaltungen mit derselben Technologie, **dadurch gekennzeichnet, dass** das System eine Tabelle (TAB) mit Eichwerten für einen Zeittakt der integrierten Schaltung umfasst, um den Zeittakt oder wenigstens einen zugehörigen Bezugswert in jede der integrierten Schaltungen einzustellen, indem an diesen gleichzeitig ein Einstellverfahren nach einem der Ansprüche 1 bis 17 angewendet wird.
